Europäisches Patentamt

European Patent Office

Office européen des brevets

(19)

(11) Veröffentlichungsnummer: **0 026 839**
**B1**

# EUROPÄISCHE PATENTSCHRIFT

(12)

(45) Veröffentlichungstag der Patentschrift:
27.07.83

(21) Anmeldenummer: **80105128.5**

(22) Anmeldetag: **28.08.80**

(51) Int. Cl.³: **H 05 K 3/36,** H 05 K 3/46,
H 05 K 3/00

(54) **Flexible gedruckte Schaltung.**

(30) Priorität: **21.09.79 DE 2938254**

(43) Veröffentlichungstag der Anmeldung:
**15.04.81 Patentblatt 81/15**

(45) Bekanntmachung des Hinweises auf die Patenterteilung:
**27.07.83 Patentblatt 83/30**

(84) Benannte Vertragsstaaten:
**BE FR IT SE**

(56) Entgegenhaltungen:
**DE-A-2 053 221**
**DE-A-2 107 591**
**DE-A-2 524 581**
**DE-A-2 807 874**

(73) Patentinhaber: **SIEMENS AKTIENGESELLSCHAFT,
Berlin und München Wittelsbacherplatz 2,
D-8000 München 2 (DE)**

(72) Erfinder: **Dörflinger, Karl, Ing.grad., Mühlthaler
Strasse 103, D-8000 München 71 (DE)**
Erfinder: **Weis, Günther, Ing.grad., Frasdorfer
Strasse 6 A, D-8000 München 90 (DE)**

Flexible gedruckte Schaltung

Die Erfindung bezieht sich auf eine flexible gedruckte Schaltung aus wenigstens einer Leiterfolie, die aus einer Isolierfolie mit ein- oder beidseitig aufgebrachten Leiterbahnen besteht, welche an vorbestimmten Stellen der Schaltung durchkontaktiert oder mit einem Anschlußstift verlötet werden, wozu ein lappenförmiges Leiterfolienstück an diesen Stellen entlang einer nicht geschlossenen Schnittlinie vom Rand einer Öffnung abgetrennt und zur Lötseite hin ausgebogen ist.

Eine solche Art der Durchkontaktierung und Verlötung ist in der DE-A-2 524 581 beschrieben.

Dabei handelt es sich um eine einzige Leiterfolie, bei der die, falls vorhanden, beiden Belagschichten am Durchbruch entweder unmittelbar miteinander oder unter Zuhilfenahme eines durchgesteckten Lötstiftes verbunden werden.

Nun ist es jedoch häufig erforderlich, nicht nur eine sondern zwei oder mehrere Leiterfolien an Bauteile schwallzulöten oder mehrere Lagen einer Folienverdrahtung, z. B. als Multilayerersatz elektrisch zu verbinden. Ferner wird es häufig gefordert, mittels Leiterfolien, eine koaxiale Leitungsverbindung zu ermöglichen.

Der Erfindung liegt die Aufgabe zugrunde, eine Methode anzugeben, auch diesem Problem gerecht zu werden, d. h. unter Zuhilfenahme der Schwallötung zwei oder mehrere Leiterfolien gegebenenfalls unter Zuhilfenahme eines Lötstiftes miteinander durchzukontaktieren.

Diese Aufgabe wird bei einer flexiblen gedruckten Schaltung aus wenigstens einer Leiterfolie, die aus einer Isolierfolie mit ein- oder beidseitig aufgebrachten Leiterbahnen besteht, welche an vorbestimmten Stellen der Schaltung durchkontaktiert oder mit einem Anschlußstift verlötet werden, wozu ein lappenförmiges Leiterfolienstück an diesen Stellen entlang einer nicht geschlossenen Schnittlinie vom Rand einer Öffnung abgetrennt und zur Lötseite hin ausgebogen ist, gemäß der Erfindung dadurch gelöst, daß mehrere Leiterfolien übereinanderliegen, daß die aus den einzelnen Leiterfolien auszubiegenden Lappen bei zunehmender Anzahl der miteinander zu verlötenden Lappen mit von Leiterfolie zu Leiterfolie kleiner werdenden Flächen ausgestanzt sind und daß in Leiterfolien, die an dieser Stelle nicht zu verlöten sind, kreisförmige Durchbrüche vorgesehen sind, deren Durchmesser größer ist als die längste Abmessung der aus darunter liegenden Leiterfolien aufgebogenen Lappen.

Es ist dabei vorteilhaft, die Lappen alle in Richtung zur Lötseite durch die Durchbrüche hindurchzuziehen und gegebenenfalls mit einem hindurchgesteckten Anschlußdraht, an dem sie zunächst federnd anliegen, zu verlöten.

Zwar sind aus der DE-A-2 053 221 insbesondere auch flexible gedruckte Schaltungen mit Leiterfolien, die aus einer Isolierfolie mit ein-

oder beidseitig aufgebrachten Leiterbahnen bestehen, welche an vorbestimmten Stellen der Schaltung durchkontaktiert oder mit einem Ausschlußstift verlötet sind, bekannt, bei denen mehrere Leiterfolien übereinanderliegen und bei denen in Leiterfolien, die an dieser Stelle nicht zu verlöten sind, kreisförmige Durchbrüche vorgesehen sind, deren Durchmesser größer ist als der Durchmesser der darunter oder darüber liegenden Durchbrüche. Jedoch wird bei dieser Art der Durchverbindung von mehreren Leiterfolien an der Verbindungsstelle ein zusätzliches hütchenförmiges lötbares Bauteil eingesetzt, durch das gegebenenfalls auch noch ein zusätzlich zu verlötender Drahtbügel durchsteckbar ist. Dieses Löthilfsmittel erschwert die Handhabung und wird bei der erfindungsgemäßen Anordnung vermieden.

Nachstehend wird die Erfindung anhand von in den Figuren dargestellten Ausführungsbeispielen näher erläutert.

Die Fig. 1 zeigt zwei übereinanderliegende Leiterfolien mit einem Lötstift.

Die Fig. 2 zeigt ebenfalls zwei übereinanderliegende Leiterfolien mit doppelter Kaschierung, die über Durchbrüche und Lötstift durchkontaktiert sind.

Die Fig. 3 zeigt die Durchkontaktierung von drei aufeinanderliegenden Leiterfolien.

Die Fig. 4 zeigt das Stanzwerkzeug und den Stanzvorgang in verschiedenen Ansichten.

Die Leiterfolien bestehen im allgemeinen aus in den Figuren dick gezeichneten Kupferschichten, die auf eine dünne Folie beidseits aufgebracht sind und im allgemeinen einen einzigen Leiter (gleiches Potential) darstellen. Dieses Dreischichtensystem ist auf beiden Außenseiten noch mit wenigstens einer dünnen Permazell-Isolierschicht überzogen, um bei Berührung mit anderen Folien Kurzschlußbrücken zu vermeiden.

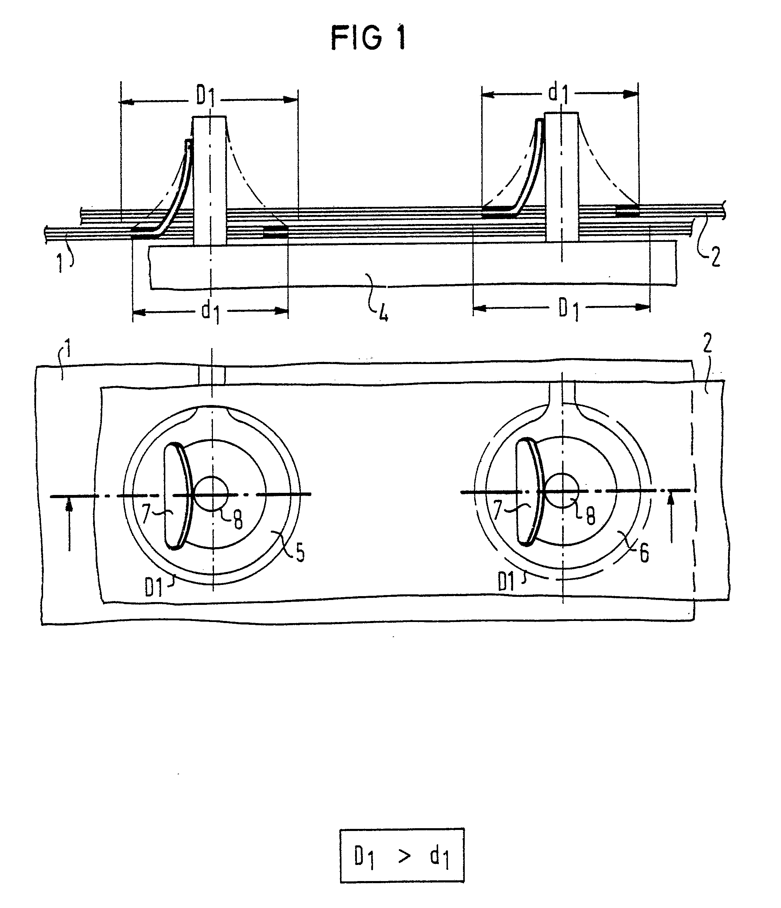

Liegen solche Leiterfolien 1 und 2 oder mehrere übereinander (Fig. 1) und muß nur eine an Anschlußstifte 8 von Bauteilen 4 gelötet werden, dann werden eine oder mehrere Leiterfolien 1 oder 2 freigeschnitten. $D_1$ ist dabei der Freischnittdurchmesser der nicht zu verlötenden Leiterfolie und $d_1$ der Lötaugendurchmesser der zu lötenden Leiterfolie. Es gilt: $D_1 > d_1$.

Der Freischnitt D1 ist ein Rundloch, das etwas größer ist als das darunter oder darüber liegende zu lötende Lötauge 5 oder 6. Die Größe des Freischnitts richtet sich nach der Toleranz der Rasterfelder, des zu lötenden Lötaugenaußendurchmessers zuzüglich eines Sicherheitsringes von etwa 0,2 mm Breite. Der Lötlappen 7 kann, wie dargestellt oder später beschrieben, ausgebildet sein.

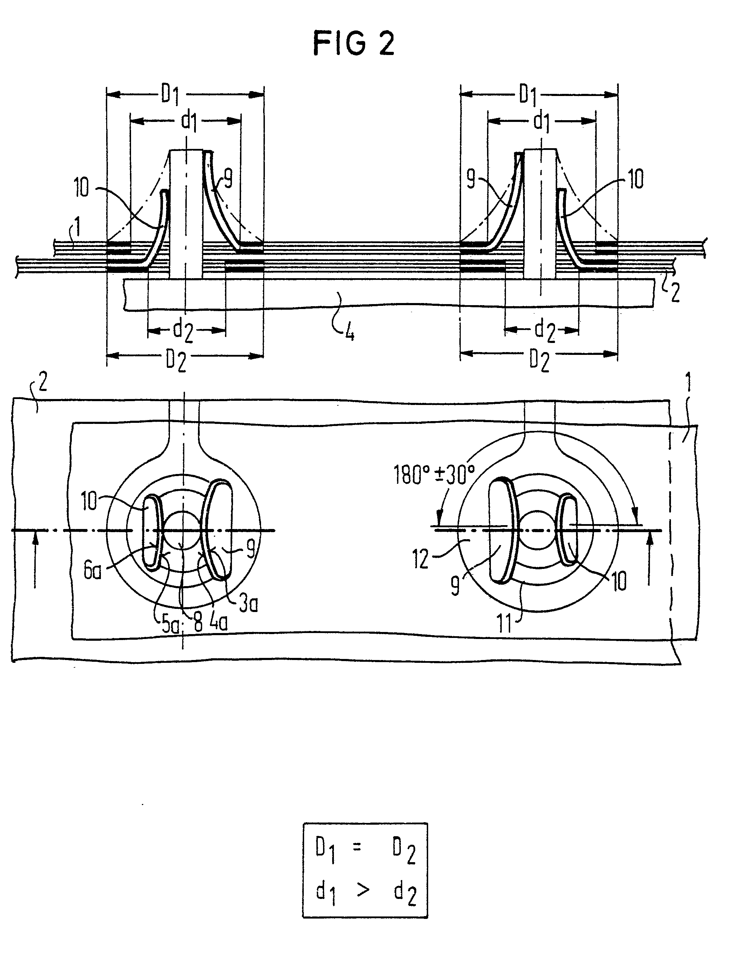

Liegen zwei Leiterfolien 1 und 2 übereinander (Fig. 2) und müssen alle vier Kaschierungsseiten 3a, 4a, 5a und 6a an Bauteileanschlußenden 8 von Bauteilen 4 gelötet werden, so erfolgt dies über Lötlappen 9 und 10. Die Lötlappen 9 und 10 werden dann schmal ausgebildet, wobei jedoch der Lötlappen 10 der unten liegenden Leiterfolie 2 um so viel kleiner sein muß, daß er durch das darüberliegende Stanzloch 11 mit dem Lappen 9 herausragt ohne Beschädigung der einen oder anderen Leiterfolie bzw. der Lötlappen 10 und der Lötaugen 12, durchschlüpft. Dem Lötschwall werden so von beiden Leiterfolien die darüber- und darunterliegende Kupferkaschierung zur Benetzung von Lötzinn angeboten. Sie sind daher auch um 180° versetzt, eine Veränderung um ±30° ist möglich. Dabei gilt:

$$D_1 = D_2$$
$$d_1 > d_2$$
$D_1 = D_2 =$ Lötaugendurchmesser beider Leiterfolien
$d_1 =$ Lötaugeninnen- bzw. Lötlappendurchmesser der oberen Leiterfolie
$d_2 =$ Lötaugeninnen- bzw. Lötlappendurchmesser der unteren Leiterfolie

Der Größenunterschied der Lappen 9 und 10 und somit auch der Lochdurchmesser $d_1$ bzw. $d_2$ der Lötaugen wird von den Rastertoleranzen der Rasterfelder beider Leiterfolien, den Toleranzen der Lötlappen bzw. Lochdurchmesser bestimmt, zuzüglich einer angemessenen Sicherheit, um ein einwandfreies Durchschlüpfen des kleineren Lötlappens 10 durch das Stanzloch 11 des größeren Lötlappens 9 sicherzustellen.

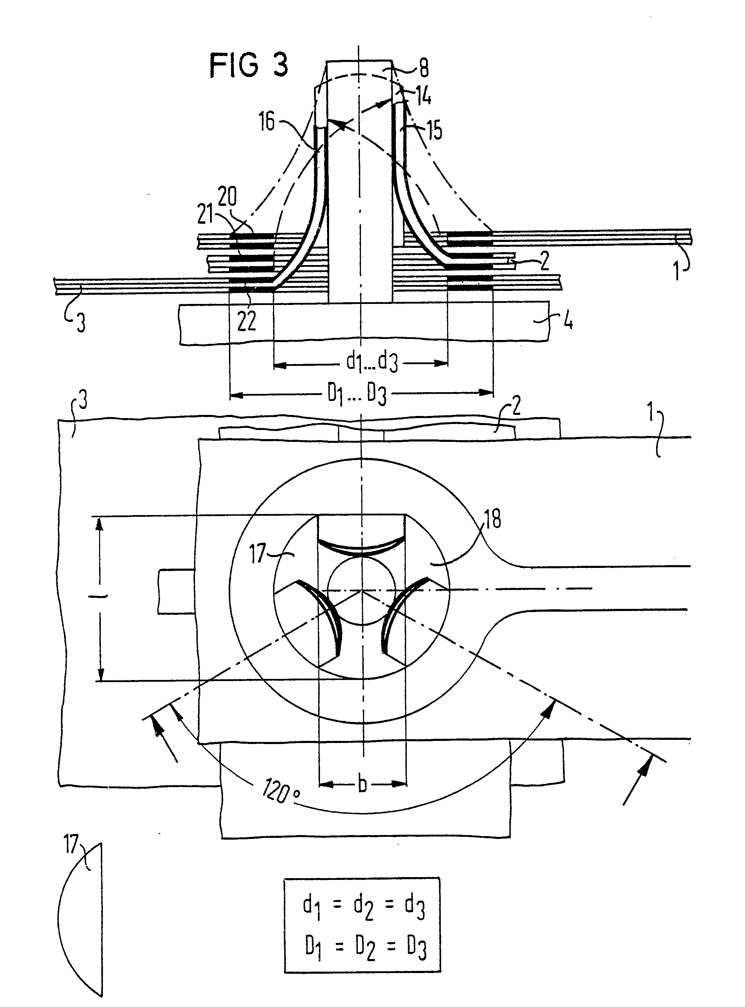

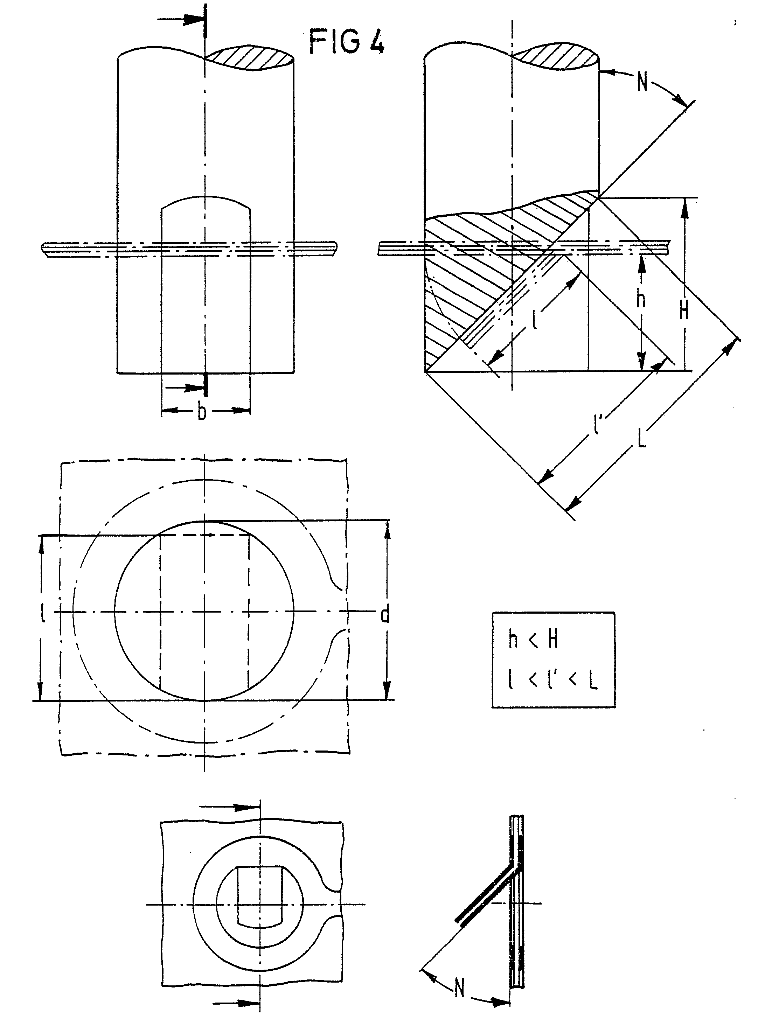

Liegen drei oder mehrere Leiterfolien, zum Beispiel 1, 2 und 3 übereinander wie in Fig. 3 dargestellt, und sind die Lappen 14, 15 und 16 von übereinander fluchtend liegenden Stanzlöchern an einen gemeinsamen Bauteile-Anschlußstift 8 zu löten, so werden Lappen und Stanzlöcher so ausgebildet, daß alle Lötlappen (zum Beispiel drei Lappen) durch Freischnitte 17 und 18 im Lötaugenstanzloch d am Bauteile-Anschlußstift entlang durchschlüpfen können und jeder Lötlappen das Kupfer beider Kaschierungsseiten dem Schwall des Lötbades zum Löten anbietet. Die nun entstandenen Lötlappen sind je nach Leiterfolienanzahl versetzt, zum Beispiel bei drei Folien um 120°, bei vier Folien um 90° usw. Der Durchmesser »d« der lappen- und freischnitterzeugenden Stanznadel, siehe auch Fig. 4, ist für alle übereinanderliegenden Leiterfolien gleich. Die Breite »b« des Lappens und die Größe der Freischnitte 17 und 18 in Abhängigkeit von der Leiterfolien- bzw. Lötlappenanzahl, die an ein und dieselben Bauteile-Anschlußstifte zu löten sind, sind festgelegt. Die Freischnitte 17 und 18 im Lötauge müssen so groß sein, daß die durchragenden Lötlappen darin Platz haben ohne die Lötaugen 20, 21 und 22 zu beschädigen, wobei gewährleistet ist, daß alle Lötaugen mit Lot benetzt werden.

Die Stanznadel gemäß Fig. 4 ist einfach herzustellen; sie ist in der Aufnahme des Stanzwerkzeuges um ihre Längsachse drehbar gelagert. Die Länge »l« des Lötlappens wird durch die Eintauchtiefe h der Stanznadel in die Leiterfolie hergestellt. Dabei gilt: h < H, wobei L die gesamte Länge der Abschrägung und H die Gesamthöhe der Nadel ist. Ferner gilt: l < l' < L; l ist dabei die Lötlappenlänge, abhängig von Nadelhub h und der Lappenneigung N. Der Stanzdurchmesser ist d.

Diese neue Lösung ermöglicht außerdem, bei mehreren übereinanderliegenden Leiterfolien, eine koaxiale Leitungsführung. Dabei ist es möglich, jeweils den Innenleiter, zum Beispiel bei einem Dreischichtensystem mit zwei Außenleiterschichten durch die Außenleiterbeläge hindurchzuführen und auf einer Seite zum Beispiel mit dem Innenleiterstift einer Koaxialbuchse zu verlöten. Das gleiche gilt natürlich auch für den der Buchse zu gelegenen Außenleiter, der dann zugleich mit einer Durchkontaktierung mit einem Lötansatz am Buchsenaußenleiter auf der gleichen Seite verlötbar ist.

Aufstellung der Figurenbezeichnungen

| | |
|---|---|
| 1, 2, 3 | = Leiterfolien |
| 3a, 4a, 5a, 6a | = Kaschierungsseiten der Folien nach Fig. 2 |
| 4 | = Bauteil |
| 5 | = Lötauge (Fig. 1) |
| 6 | = Lötauge (Fig. 1) |
| 7 | = Lötlappen (Fig. 1) |
| 8 | = Bauteile-Anschlußstift |
| 9, 10 | = Lötlappen (Fig. 2) |
| 11 | = Stanzloch (Fig. 2) |
| 12 | = Lötaugen (Fig. 2) |
| 14, 15, 16 | = Lötlappen (Fig. 3) |
| 17, 18 | = Freischnitte (Fig. 3) |
| 20, 21, 22 | = Lötaugen (Fig. 3) |

**Patentansprüche**

1. Flexible gedruckte Schaltung aus wenigstens einer Leiterfolie (1, 2, 3), die aus einer Isolierfolie mit ein- oder beidseitig aufgebrachten Leiterbahnen besteht, welche an vorbestimmten Stellen der Schaltung durchkontaktiert oder mit einem Anschlußstift (8) verlötet werden, wozu ein lappenförmiges Leiterfolienstück (7, 9, 10, 14, 15, 16) an diesen Stellen entlang einer nicht geschlossenen Schnittlinie vom Rand einer Öffnung abgetrennt und zur Lötseite hin ausgebogen ist, dadurch gekennzeichnet, daß mehrere Leiterfolien (1, 2, 3) übereinanderliegen, daß die aus den einzelnen Leiterfolien auszubiegenden Lappen (7, 9, 10, 14, 15, 16) bei zunehmender Anzahl der miteinander zu verlötenden Lappen (7, 9, 10, 14, 15, 16) mit von Leiterfolie zu Leiterfolie kleiner werdenden Flächen ausgestanzt sind und daß in Leiterfolien, die an dieser Stelle nicht zu verlöten sind, kreisförmige Durchbrüche vorgesehen sind, deren Durchmesser größer ist als die längste Abmessung der aus darunterliegenden Leiterfolien aufgebogenen Lappen.

2. Flexible gedruckte Schaltung nach Anspruch 1, dadurch gekennzeichnet, daß die Lappen (7, 9, 10, 14, 15, 16) alle in Richtung zur Lötseite durch die Durchbrüche hindurchgezogen sind und mit einem hindurchgesteckten Anschlußstift (8), an dem sie zunächst federnd anliegen, verlötet sind.

## Claims

1. A flexible printed circuit comprising at least one conductor film (1, 2, 3) which consists of an insulating film having conductor paths applied on one or both sides thereof, which conductor paths at specific points of the circuit, are through-contacted or soldered to a connecting pin (8), for which purpose a tab-shaped piece of the conductor film (7, 9, 10, 14, 15, 16) is separated from the edge of an opening at these points along a line of cut which is not closed, and is bent outwardly towards the soldering side, characterised in that a plurality of conductor films (1, 2, 3) are superimposed, that the tabs (7, 9, 10, 14, 15, 16) which are outwardly bent from the individual conductor films are punched out with surfaces which become smaller from conductor film to conductor film with increasing number of the tabs (7, 9, 10, 14, 15, 16) which are to be soldered to one another; and that in conductor films, which are not to be soldered at this point, there are arranged circular apertures, the diameter of which is greater than the longest dimension of the tabs which are upwardly bent from underlying conductor films.

2. A flexible printed circuit as claimed in Claim 1, characterised in that the tabs (7, 9, 10, 14, 15, 16) are all drawn through the apertures in the direction towards the soldering side and are soldered to an inserted connecting pin (8) against which they first abut in resilient manner.

## Revendications

1. Circuit imprimé souple comportant au moins une feuille de circuit imprimé (1, 2, 3) qui est constituée par une feuille isolante comportant des pistes conductrices, déposées d'un ou des deux côtés, qui sont mises en contact par une connexion transversale ou sont brasées avec une broche de raccordement en des endroits prédéterminés du circuit, un morceau de feuille de circuit imprimé en forme de languette (7, 9, 10, 14, 15, 16) étant séparé en ces endroits du bord d'une ouverture, suivant une ligne de coupe non fermée, et replié en direction du côté brasage, caractérisé par le fait que plusieurs feuilles de circuit imprimé (1, 2, 3) sont disposées les unes au-dessus des autres, que les languettes (7, 9, 10, 14, 15, 16) qui doivent être repliées à partir des feuilles de circuit imprimé individuelles sont découpées avec des surfaces qui diminuent de feuilles de circuit imprimé en feuille de circuit imprimé lorsque le nombre de languettes (7, 9, 10, 14, 15, 16) à braser ensemble augmente, et que dans les feuilles de circuit imprimé qui n'ont pas à être brasées à cet endroit sont prévues des ouvertures circulaires dont le diamètre est plus important que la dimension la plus longue des languettes repliées à partir des feuilles de circuit imprimé sous-jacentes.

2. Circuit imprimé souple suivant la revendication 1, caractérisé par le fait que les languettes (7, 9, 10, 14, 15, 16) sont toutes passées, dans la direction du côté de brasage, à travers les ouvertures, et sont soudées avec une broche de raccordement enfichée (8) sur laquelle elles s'appuyent tout d'abord élastiquement.

# FIG 1

$$D_1 > d_1$$

# FIG 2

$$D_1 = D_2$$
$$d_1 > d_2$$

# FIG 3

$$d_1 = d_2 = d_3$$
$$D_1 = D_2 = D_3$$

# FIG 4

$$h < H$$
$$l < l' < L$$

11